# EUROPÄISCHE PATENTANMELDUNG

(11) **EP 4 651 090 A1**
(43) Veröffentlichungstag der Anmeldung: **19.11.2025**
(21) Anmeldenummer: 24176629.4
(22) Anmeldetag: 17.05.2024
(51) Int. Cl.: G06T 15/06

(54) **VERFAHREN ZUM GENERIEREN EINES VIRTUELLEN RAYTRACING-SENSORSIGNALS**

(71) Anmelder: dSPACE GmbH, 33102 Paderborn (DE)
(72) Erfinder: Götte, Matthias, 33102 Paderborn (DE)

(57) **Zusammenfassung**

Die vorliegende Erfindung betrifft ein computerimplementiertes Verfahren und System zum Generieren eines virtuellen Raytracing-Sensorsignals eines virtuell zu testenden Fahrzeugsensors (200) zum Testen einer virtuell simulierten, insbesondere autonomen, Fahrfunktion eines Ego-Fahrzeuges (202).

## Beschreibung

Die Erfindung betrifft ein computerimplementiertes Verfahren zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges.

Die Erfindung betrifft des Weiteren ein System zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges.

Die Erfindung betrifft ferner ein Computerprogrammprodukt mit einem Computerprogramm sowie einen computerlesbaren Datenträger mit Programmcode eines Computerprogramms.

### Stand der Technik

In der sich ständig weiterentwickelnden Welt der Fahrzeugtechnologie nimmt die Bedeutung der Simulation einen immer größeren Stellenwert ein, insbesondere bei der Entwicklung und dem Testen autonomer Fahrfunktionen.

Ein Element in diesem Kontext ist der Einsatz virtueller Sensoren, die dazu dienen, die reale Umgebung eines Fahrzeugs im virtuellen Raum nachzubilden. Unter diesen virtuellen Sensoren stellt der Raytracing-Sensor eine Schlüsseltechnologie dar.

Raytracing, eine Technik, die ursprünglich aus der Computergrafik stammt, findet aufgrund ihrer Fähigkeit, Licht und dessen Interaktion mit verschiedenen Oberflächen realitätsnah zu simulieren, nun auch Anwendung in der Simulation von Fahrzeugsensoren.

Verfahren zur Generierung eines virtuellen Raytracing-Sensorsignals, das zur Prüfung und Validierung der Funktionen eines autonomen Fahrzeugs, dem sogenannten Ego-Fahrzeug, in einer virtuell simulierten Umgebung eingesetzt wird, sind grundsätzlich bekannt.

Durch die realitätsnahe Nachbildung der sensorischen Erfassung der Umgebung ermöglicht dieser Ansatz eine detaillierte und umfassende Evaluierung der Leistungsfähigkeit und Zuverlässigkeit autonomer Fahrsysteme, ohne die Notwendigkeit physischer Tests unter potenziell gefährlichen Bedingungen.

Die bekannten Verfahren und Systeme haben jedoch den Nachteil, dass oftmals viel Rechenzeit und Rechenressourcen benötigt werden. Somit besteht in diesem Kontext weiterhin Entwicklungspotenzial.

Es ist daher Aufgabe der Erfindung, ein verbessertes Verfahren und/oder System zum Generieren eines virtuellen Raytracing-Sensorsignals anzugeben.

### Offenbarung der Erfindung

Die Aufgabe wird durch ein computerimplementiertes Verfahren zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges mit den Merkmalen des Patentanspruchs 1 gelöst. Ferner wird die Aufgabe gelöst durch ein Verfahren nach Patentanspruch 16.

Die Aufgabe wird des Weiteren durch ein System zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges mit den Merkmalen des Patentanspruchs 13 gelöst.

Die Aufgabe wird ferner gelöst durch ein Computerprogrammprodukt mit einem Computerprogramm gemäß Anspruch 14 sowie durch einen computerlesbaren Datenträger mit Programmcode eines Computerprogramms gemäß Anspruch 15.

Die Erfindung betrifft ein computerimplementiertes Verfahren zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges.

Das Verfahren umfasst ein:
- Bereitstellen von Szeneninformationen in einem ersten, insbesondere 64-Bit basierten, Datenformat, wobei die Szeneninformationen Informationen über das Ego-Fahrzeug und mindestens ein Objekt im Raum aufweisen;
- Bereitstellen der Szeneninformationen in einem zweiten, insbesondere 64-Bit basierten, Datenformat, das auf Basis des ersten Datenformats umgewandelt wird;
- Bereitstellen der Szeneninformationen in einem dritten, insbesondere 32-Bit basierten, Datenformat, das auf Basis des zweiten Datenformats umgewandelt wird, und zum virtuellen Raytracing mindestens eines Objektes im Raum verwendet wird;
- in dem dritten Datenformat, Unterteilen des Raumes gemäß einem Suchgitter und Ermitteln, welches des mindestens einen Objektes mit einem approximierten Strahl des virtuell zu testenden Fahrzeugsensors interagiert;
- in dem dritten Datenformat, virtuelles Raytracing des ermittelten, mindestens einen Objektes; und
- Generieren des virtuellen Raytracing-Sensorsignals auf Basis des getracten, mindestens einen Objektes zum Testen der virtuell simulierten, insbesondere autonomen, Fahrfunktion des Ego-Fahrzeuges.

Das Verfahren umfasst in einem alternativen Aspekt ein:
- Bereitstellen von Szeneninformationen in einem ersten, insbesondere 64-Bit basierten, Datenformat, wobei die Szeneninformationen Informationen über das Ego-Fahrzeug und mindestens ein Objekt im Raum aufweisen;
- Bereitstellen der Szeneninformationen in einem dritten, insbesondere 32-Bit basierten, Datenformat, das auf Basis des ersten Datenformats umgewandelt wird, und zum virtuellen Raytracing mindestens eines Objektes im Raum verwendet wird;
- in dem dritten Datenformat, Unterteilen des Raumes gemäß einem Suchgitter und Ermitteln, welches des mindestens einen Objektes mit einem approximierten Strahl des virtuell zu testenden Fahrzeugsensors interagiert;
- in dem dritten Datenformat, virtuelles Raytracing des ermittelten, mindestens einen Objektes; und
- Generieren des virtuellen Raytracing-Sensorsignals auf Basis des getracten, mindestens einen Objektes zum Testen der virtuell simulierten, insbesondere autonomen, Fahrfunktion des Ego-Fahrzeuges.

Gemäß dem alternativen Aspekt des Verfahrens können die Szeneninformationen in dem dritten Datenformat auch direkt aus Szeneninformationen des ersten Datenformats gewonnen werden, insbesondere, ohne dass ein Überführen in das zweite Datenformat erfolgt. Die Überführung von dem ersten in das zweite und von dem zweiten in das dritte Datenformat ist zwar bevorzugt, allerdings kann auch ein direktes Überführen von dem ersten in das dritte Datenformat erfolgen. Die Ausführungsformen gelten für beide Verfahren entsprechend, ohne in Redundanz genannt werden zu müssen.

Es versteht sich, dass die erfindungsmäßen Schritte sowie weitere optionale Schritte nicht notwendigerweise in der aufgezeigten Reihenfolge ausgeführt werden müssen, sondern auch in einer anderen Reihenfolge ausgeführt werden können. Ferner können weitere Zwischenschritte vorgesehen sein. Die einzelnen Schritte können zudem einen oder mehrere Unterschritte umfassen, ohne dass hierdurch der Umfang des erfindungsgemäßen Verfahrens verlassen wird.

Die Erfindung betrifft des Weiteren ein System zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges, das System aufweisend eine Auswerte- und Recheneinrichtung.

Das System ist dazu ausgebildet, die folgenden Schritte auszuführen:
- Bereitstellen (S1A) von Szeneninformationen in einem ersten, insbesondere 64-Bit basierten, Datenformat, wobei die Szeneninformationen Informationen über das Ego-Fahrzeug und mindestens ein Objekt im Raum aufweisen;
- Bereitstellen (S1B) der Szeneninformationen in einem zweiten, insbesondere 64-Bit basierten, Datenformat, das auf Basis des ersten Datenformats umgewandelt wird;
- Bereitstellen (S1C) der Szeneninformationen in einem dritten, insbesondere 32-Bit basierten, Datenformat, das auf Basis des zweiten Datenformats umgewandelt wird, und zum virtuellen Raytracing mindestens eines Objektes im Raum verwendet wird;
- in dem dritten Datenformat, Unterteilen (S2) des Raumes gemäß einem Suchgitter und Ermitteln (S3), welches des mindestens einen Objektes mit einem approximierten Strahl des virtuell zu testenden Fahrzeugsensors interagiert;
- in dem dritten Datenformat, virtuelles Raytracing (S5) des ermittelten, mindestens einen Objektes; und
- Generieren (S6) des virtuellen Raytracing-Sensorsignals auf Basis des getracten, mindestens einen Objektes zum Testen der virtuell simulierten, insbesondere autonomen, Fahrfunktion des Ego-Fahrzeuges.

Die für das Verfahren gemachten Ausführungen gelten für die Vorrichtung entsprechend. Dabei versteht es sich, dass sprachliche Abwandlungen von verfahrensmäßig formulierten Merkmalen nach sprachüblicher Praxis für die Vorrichtung umformulierbar sind, ohne dass derartige Formulierungen explizit hier aufgeführt werden müssen.

In bisherigen Verfahren und Systemen zum Generieren eines virtuellen Raytracing-Sensorsignals eines virtuell zu testenden Fahrzeugsensors, insbesondere eines Raytracing-Sensors, wie Lidar, Radar, Ultraschall, kommt es neben rechenleistungsbedingten Problemen immer wieder zu Problemen bei der Genauigkeit der Sensorsimulation. Bislang wird für derartige Raytracing-Sensoren eine Bildszene, insbesondere pro Frame, in dem zweiten Datenformat (Unreal Engine 5) in das dritte Datenformat (eine Nvidia Optix Szene) geparsed.

Die Informationen in dem dritten Datenformat liegen dabei zumeist als eine Art Baumstruktur vor. Bislang wird dabei ein statischer bzw. sich nicht bewegender Anteil der jeweiligen Szene in eine feststehende Datenstruktur übersetzt, in der beispielsweise die Vertices (jedes Dreieck) in der Szene durch absolute Weltkoordinaten beschrieben ist. Der Ursprung des Weltkoordinatensystems liegt dabei in einem im Kontext dieser Erfindung willkürlichen Punkt innerhalb der Szene. Dies führt jedoch im Allgemeinen zu Problemen bei der Genauigkeit der Sensorsimulation, da das dritte Datenformat (Nvidia Optix) mit 32-Bit Gleitkommazahlen gemäß dem Standard IEEE 754-2008 arbeitet. Hierdurch kommt es zu Datenverlusten über wichtige Details der Szene. Beispielswese erscheint eine runde Oberfläche eines Objektes in der Simulation des Raytracings nicht mehr glatt, sondern abgestuft, wenn der Abstand zum Koordinatenursprung groß ist. Zudem nehmen bei größeren Szenen der Speicherverbrauch sowie der Rechenaufwand nichtlinear zu. Dies führt zu einer Abnahme der Tracingperformance.

Die zuvor beschriebenen Probleme konnten durch das vorliegende Verfahren und System gelöst werden.

Dabei wird in dem dritten Datenformat, der Raum gemäß einem Suchgitter unterteilt und es wird ermittelt, welches des mindestens einen Objektes mit einem approximierten Strahl des virtuell zu testenden Fahrzeugsensors interagiert. Mit anderen Worten werden die in den Szenen abgebildeten statischen bzw. sich nicht bewegenden Objekte bzw. die statische Umgebung in Sektionen (Chunks) aufgeteilt. Dies ermöglicht es während der Simulation des Raytracings zu prüfen, welche Teile bzw. Sektionen der statischen Welt für den simulierten Fahrzeugsensor relevant sind. Somit können auch nur diese Sektionen berücksichtigt werden.

Somit sind nur solche Objekte, die in Reichweite eines zu simulierenden Fahrzeugsensors sind, Teil einer finalen Auswertestruktur. Die Zuordnung zu Sektionen mit fester Beschleunigungsstruktur, gegenüber der individuellen Berücksichtigung einzelner Objekte hat dabei den Vorteil, dass die Anzahl der Relevanzprüfungen und die Anzahl individueller Sub-Datenstrukturen in dem dritten Datenformat (Optix-Szene) reduziert wird, und insbesondere unabhängig von einer lokalen Häufung von Objekten ist. Dies erhöht die Performance des zugrundeliegenden Raytracing-Algorithmus. Durch das vorliegende Verfahren kann eine hohe Simulationsgenauigkeit und eine hohe Simulationsgeschwindigkeit bei der Simulation von Raytracing Sensoren, insbesondere unabhängig von einer Größe der simulierten Szene, erreicht werden.

Vorliegend ermöglicht die Sektionierung der Szene in Sektionen bzw. kleinere Szenen bzw. Szenenausschnitten eine besseren Raytracing-Performance, da nicht benötigte Teile der Szene beispielsweise aus dem Grafikkartenspeicher auf den Hostspeicher verschoben werden können. Somit können beispielsweise auch mehr Fahrzeugsensoren gleichzeitig pro Grafikkarte simuliert und berechnet werden. Alternativ oder ergänzend können auch deutlich größere Ausgangs-Szenen simuliert und berechnet werden. Die bislang auftretenden Rechenleistungsprobleme sind somit gelöst und müssen nicht mehr als Limitation akzeptiert werden.

Bei dem ersten Datenformat handelt es sich vorzugsweise um ein Modeldesk-Datenformat. Bei dem zweiten Datenformat handelt es sich vorzugsweise um ein Unreal 5-Datenformat. Bei dem dritten Datenformat handelt es sich vorzugsweise um ein Nvidia Optix-Datenformat.

ModelDesk ist eine Softwareumgebung, die oft in Verbindung mit dSpace-Systemen verwendet wird. Das ModelDesk-Datenformat bezieht sich auf die Art und Weise, wie Daten und Projekte innerhalb der ModelDesk-Software gespeichert und organisiert werden. Diese Software wird für die Parametrierung, Verwaltung und Optimierung von Modellen in Echtzeitsimulationen verwendet, insbesondere in der Automobilindustrie für die Entwicklung von Fahrerassistenzsystemen und anderen Fahrzeugsteuerungssystemen.

Unreal Engine 5 (UE5) ist eine weit verbreitete und leistungsstarke Spiel-Engine, die von Epic Games entwickelt wurde. Das Datenformat in UE5 bezieht sich auf die Art und Weise, wie Assets, Szenen, Materialien, Texturen und andere Elemente innerhalb der Engine gespeichert und gehandhabt werden. UE5 verwendet eine Vielzahl von Dateiformaten, darunter proprietäre Formate wie .uasset für Assets. Diese Formate sind optimiert, um die leistungsstarken Funktionen der Engine, wie z.B. photorealistisches Raytracing, dynamische Beleuchtung und hochentwickelte Materialsysteme, zu unterstützen.

OptiX ist ein Anwendungsframework von NVIDIA für GPUbeschleunigtes Raytracing. Das "Datenformat" in OptiX bezieht sich wahrscheinlich auf die Art und Weise, wie Szenen, Geometrien, Materialien und Shader innerhalb des Frameworks definiert und organisiert werden, um Raytracing-Berechnungen zu ermöglichen. OptiX arbeitet mit einer Vielzahl von Datenformaten und bietet Schnittstellen für die Integration in bestehende Rendering-Pipelines, wobei CUDA als Grundlage für die Beschreibung von Raytracing-Operationen dient.

Besonders bevorzugt erfolgt das Ermitteln, welches des mindestens einen Objektes mit einem approximierten Strahl des virtuell zu testenden Fahrzeugsensors interagiert, in jedem oder für jeden (neuen) Frame.

Virtuelles Raytracing eines Objektes im Raum bezieht sich auf eine computergestützte Technik, die zur Simulation des Weges von Strahlen durch eine virtuelle Umgebung verwendet wird, um beispielsweise die visuellen Effekte zu erzeugen, die entstehen, wenn Licht auf Objekte trifft. Diese Methode wird insbesondere in der Computergrafik, sowie bei der Entwicklung von Visualisierungs-, optischen oder beleuchtungstechnischen Systemen eingesetzt. Sie findet aber auch in der Simulation von Sensorsystemen für Fahrzeuge Anwendung.

Der Prozess des virtuellen Raytracings beginnt vorzugsweise mit den Ausgangspunkten der Strahlen. Von hier aus werden Strahlen durch die virtuelle Szene verfolgt. Die Wahl der Ausgangspunkte bzw. die Richtung der Strahlen richtet sich dabei nicht nach der Physik, sondern nach dem Berechnungsaufwand. So ist es bspw. in der Computergrafik üblich Strahlen rückwärts ausgehend von einem sogenannten "Auge" zu verfolgen, wohingegen Berechnungen in der Beleuchtungstechnik in der Regel von einer Lichtquelle ausgehen. Wenn ein Strahl auf ein Objekt trifft, werden die Interaktionen mit der Oberfläche des Objekts berechnet, einschließlich Reflexion, Brechung und Absorption, insbesondere basierend auf den Materialeigenschaften des Objekts. Durch die Anwendung des Raytracing-Verfahrens auf Objekte in einem virtuellen Raum ist es möglich die physikalischen Eigenschaften von Licht und Materialien genau nachzubilden. In der Anwendung auf Fahrzeugsensoren kann diese Technik dazu verwendet werden, die Interaktion von aktiven Sensoren mit der Fahrzeugumgebung zu simulieren. Diese Sensoren, wie beispielsweise Lidar, Radar oder Ultraschall, senden zur Messung ein (Sensor-)signal aus, welches mit Objekten und Oberflächen der Umgebung so wechselwirkt, dass zumindest ein Teil des Signals zum Sensor zurück gelangt. Durch die Simulation können Entwickler die Leistung von Sensorsystemen unter verschiedenen Bedingungen und Szenarien präzise testen und validieren, ohne auf physische Prototypen oder Tests angewiesen zu sein.

Ein approximierter Strahl beim Raytracing ist somit Teil einer vereinfachten Darstellung von physikalischen Wellen, insbesondere elektromagnetischer oder akustischer Wellen, durch einen oder mehrere Strahlen im mathematisch-geometrischen Sinn, die verwendet wird, um die Berechnungseffizienz zu verbessern, insbesondere in Situationen, in denen eine perfekt präzise Simulation von Wellenphänomenen nicht unbedingt erforderlich ist. Die Approximation kann dabei noch weiter vereinfacht werden, beispielsweise durch die Reduzierung der Präzision bei der Berechnung der Strahlausbreitung oder durch die Annahme vereinfachter Interaktionsmodelle beim Auftreffen des Strahls auf Objekte. Ziel ist es, die Anzahl der erforderlichen Berechnungen zu verringern, indem Detailgrad oder Genauigkeit in Bereichen reduziert werden, die weniger kritisch für das Endergebnis sind.

Ein Suchgitter, auch bezeichnet als Raumunterteilungsgitter oder Spatial Hashing Grid, ist eine Methode zur Organisation und Optimierung der Raytracing-Berechnungen in einer dreidimensionalen Szene. Dabei wird der Raum in ein Gitter aus kleineren, diskreten Zellen Sektionen unterteilt. Jedes Objekt in der Szene wird einer oder mehreren dieser Zellen zugeordnet, basierend auf seiner Position und Ausdehnung. Wenn ein Strahl durch die Szene verfolgt wird, muss das Raytracing-System nicht mehr die gesamte Szene nach potenziellen Kollisionen mit Objekten durchsuchen. Stattdessen überprüft es nur die Objekte in den Zellen, durch die der Strahl verläuft.

Diese Methode verbessert die Effizienz von Raytracing, insbesondere in komplexen Szenen mit vielen Objekten, da sie die Anzahl der notwendigen Kollisionsberechnungen zwischen Strahlen und Objekten reduziert. Durch die Reduzierung der Menge an Überprüfungen, die für jeden Strahl erforderlich sind, kann die Gesamtberechnungszeit für das Raytracing einer Szene drastisch verringert werden, was besonders wichtig für Echtzeitanwendungen wie interaktive Grafiken oder die Simulation von Sensorsignalen in Echtzeit ist.

In einem weiteren Aspekt wird vorgeschlagen, dass das Verfahren ferner aufweist:
- Transformieren (S4A) von Koordinaten des ermittelten, mindestens einen Objektes aus dem Welt-Koordinatensystem in ein Koordinatensystem des virtuell zu testenden Fahrzeugsensors auf Basis von Ortsinformationen des ermittelten, mindestens einen Objektes und/oder des Fahrzeugsensors, die aus dem zweiten Datenformat gewonnen werden, und auf Basis von Strahleninformationen des approximierten Strahl; oder
- Transformieren (S4B) von Koordinaten des Fahrzeugsensors aus dem Welt-Koordinatensystem in ein Koordinatensystem des ermittelten, mindestens einen Objektes auf Basis von Ortsinformationen des ermittelten, mindestens einen Objektes und/oder des Fahrzeugsensors, die aus dem zweiten Datenformat gewonnen werden, und auf Basis von Strahleninformationen des approximierten Strahls.

Die Transformation kann durch einen beliebigen Koordinatentransformationsalgorithmus erfolgen. Diese wird vorzugsweise so gewählt, dass entweder der Fahrzeugsensor oder das Objekt im oder in der Nähe des Ursprungs des Koordinatensystems liegen. Beides führt dazu, dass die Einträge der die das Objekt bzw. den Fahrzeugsensor betreffenden Ortsvektoren kleiner werden.

Durch die Unterteilung einer großen statischen Ausgangsszene in kleine Sektionen ist es möglich, nur benötigte Teilbereiche der Szene (z.B. die den Fahrzeugsensor umgebenen Sektionen) wie beschrieben in das Sensor- oder Objektkoordinatensystem zu transformieren. Durch die Koordinatentransformation sind alle absoluten (Bezugs-) Koordinaten klein und das Genauigkeitsproblem ist gelöst. Die Transformationsmatrizen werden dabei vorzugsweise aus den Ortsvektoren bestimmt, die aus dem zweiten Datenformat mit 64-Bit float Genauigkeit bekannt sind und damit bis zu sehr viel größeren Koordinaten eine hohe Genauigkeit bereitstellen.

In einem weiteren Aspekt wird vorgeschlagen, dass die Ortsinformationen des ermittelten, mindestens einen Objektes und/oder des Fahrzeugsensors, die aus dem zweiten Datenformat gewonnen werden, Informationen über Koeffizienten einer Transformationsmatrix aufweisen.

Besonders bevorzugt kann auf Basis des zweiten Datenformats auch eine Ortsinformation und/oder eine Bounding-Box-Information zu dem mindestens einen Objekt ermittelt bzw. bereitgestellt werden.

Bounding-Box-Informationen beschreiben die räumlichen Grenzen eines Objekts innerhalb eines definierten Raumes. Eine Bounding Box ist in der Regel ein einfaches geometrisches Volumen oder eine Form, wie ein Rechteck (in 2D) oder ein Quader (in 3D), das das Objekt vollständig umschließt.

Die Ortsinformationen können auch absolute und/oder relative Ortsinformationen zu dem mindestens eine Objekt aufweisen.

Eine Transformationsmatrix ist ein mathematisches Werkzeug, das in vielen Bereichen wie Computergrafik, Robotik, Physik und mehr verwendet wird, um verschiedene Arten von Transformationen wie Translation (Verschiebung), Rotation, Skalierung und Scherung an Objekten in einem mehrdimensionalen Raum durchzuführen. Die Koeffizienten innerhalb einer Transformationsmatrix repräsentieren die spezifischen Eigenschaften und das Ausmaß der Transformation, die auf ein Objekt oder einen Punkt angewendet wird.

Die Koeffizienten einer Transformationsmatrix definieren, wie ein Punkt und/oder Objekt im Raum transformiert wird. Durch Multiplikation der Matrix mit einem Vektor, der die Position eines Punktes repräsentiert, erhält man einen neuen Vektor, der die Position des Punktes nach Anwendung der Transformation angibt. Transformationsmatrizen können auch miteinander multipliziert werden, um komplexe Transformationen durch eine einzige Matrix darzustellen.

In einem weiteren Aspekt wird vorgeschlagen, dass die Szeneninformation ferner eine Bewegungsinformation des Ego-Fahrzeuges und/oder eine Orts- und/oder Bewegungsinformation zu dem mindestens einen Objekt aufweist.

Die Bewegungsinformationen können Informationen über eine insbesondere richtungsabhängige Geschwindigkeit und/oder insbesondere richtungsabhängige Beschleunigung aufweisen. Ferner können die Bewegungsinformationen auch Informationen über eine zukünftige Geschwindigkeits- und/oder Beschleunigungsänderung aufweisen, beispielsweise als eine Art Vektor-Flow Information zwischen Szenen und/oder Szenenausschnitten.

In einem weiteren Aspekt wird vorgeschlagen, dass das virtuelle Raytracing-Sensorsignal Informationen über einen Abstand und/oder eine Geschwindigkeit des mindestens einen Objektes relativ zu dem Ego-Fahrzeug aufweist.

Die Informationen über einen Abstand und/oder eine Geschwindigkeit können auch Informationen über eine Änderung eines Abstandes und/oder einer Geschwindigkeit aufweisen.

In einem weiteren Aspekt wird vorgeschlagen, dass das erste Datenformat eine, insbesondere abstrakte, Modellierung des mindestens einen Objekts im Raum, einen Verweis und/der Zeiger auf eine detaillierte Beschreibung des mindestens einen Objekts in dem zweiten Datenformat aufweist, und wobei das erste Datenformat vorzugsweise ein Modeldesk-Datenformat aufweist.

Das erste Datenformat bietet eine abstrakte Modellierung des Objekts, während das zweite Datenformat eine detaillierte Beschreibung liefert. Das erste Datenformat weist eine vereinfachte oder abstrahierte Darstellung des Objekts auf. Diese Abstraktion kann in Form einer Bounding Box, eines Platzhalters oder einer anderen vereinfachten Geometrie sein, die das Objekt im Raum repräsentiert, ohne auf feine Details einzugehen. Die Verwendung einer abstrakten Modellierung im ersten Datenformat dient dazu, die Verarbeitungsgeschwindigkeit zu erhöhen, insbesondere in Prozessen, wo eine vollständige Detailtreue nicht erforderlich ist, wie beispielsweise in vorläufigen Kollisionsüberprüfungen oder bei der schnellen räumlichen Analyse. Im Gegensatz zum ersten Format enthält das zweite Datenformat eine umfassende und detaillierte Beschreibung des Objekts.

Dies kann Texturinformationen, exakte Geometrien, Materialien, physikalische Eigenschaften und mehr umfassen. Das zweite Format dient vorzugsweise als Ergänzung zum ersten, indem es die Informationen bereitstellt, die für detaillierte Analysen, Renderings oder Simulationen erforderlich sind. Es wird typischerweise dann referenziert, wenn die abstrakte Darstellung für eine spezifische Anwendung nicht ausreicht.

In einem weiteren Aspekt wird vorgeschlagen, dass das erste Datenformat ferner Daten und/oder Informationen aus einer Fahrdynamiksimulation des Ego-Fahrzeuges aufweist.

Grundsätzlich können hierbei beliebige Informationen zu der Fahrdynamiksimulation des Ego-Fahrzeuges einbezogen werden. Bei einer Fahrdynamiksimulation eines Ego-Fahrzeugs werden verschiedene Aspekte des Fahrzeugs und seiner Interaktion mit der Umgebung modelliert, um das Verhalten und die Leistung des Fahrzeugs unter verschiedenen Bedingungen und Szenarien zu analysieren. Beispielhaft sei die Gesamtmasse des Fahrzeugs sowie die Verteilung des Gewichts auf die Vorder- und Hinterachse zu nennen. Ferner können die Trägheitsmomente des Fahrzeugs um die drei Hauptachsen, die die Reaktion des Fahrzeugs auf Drehbewegungen beeinflussen, simuliert werden. Ferner kann der Luftwiderstandsbeiwert (Cw-Wert) und die Querschnittsfläche des Fahrzeugs, die den Luftwiderstand bestimmen, sowie aerodynamische Abtriebskräfte, simuliert werden. Ferner kann die Motorcharakteristik, beispielsweise eine Leistungskurve, maximales Drehmoment und Drehmomentverlauf des Motors über den gesamten Drehzahlbereich, simuliert werden. Ferner kann das Getriebe und/oder eine Antriebsart (Front, Heck, Allrad) simuliert werden. Es kann die Fahrwerksdynamik, beispielsweise eine Federung, eine Lenkung, Räder und Reifen, simuliert werden.

In einem weiteren Aspekt wird vorgeschlagen, dass das zweite Datenformat die detaillierte Beschreibung des mindestens einen Objekts als Informationen über eine Beschaffenheit und/oder eine Oberfläche und/oder eine Oberflächeneigenschaft und/oder eine Objektklasse und/oder einen Objekttyp aufweist, und wobei das zweite Datenformat vorzugsweise ein Unreal Engine Datenformat aufweist.

Besonders bevorzugt werden dadurch Absorptions- und/oder Reflexions- und Streueigenschaften des mindestens einen Objektes durch physikalische Parameter beschrieben, die in dem Raytracing-Algorithmus dann für die Berechnung verwendet werden.

In einem weiteren Aspekt wird vorgeschlagen, dass das dritte Datenformat Informationen über Vertices, in die eine Oberfläche des mindestens einen Objekt unterteilt ist, aufweist, wobei die Informationen über die Vertices zum Generieren des virtuellen Raytracing-Sensorsignals in Abhängigkeit des mindestens einen, approximierten Strahl verwendet werden, wobei das dritte Datenformat ein Nvidia Optix-Datenformat aufweist.

Vertices (Singular: Vertex) sind Elemente in der Geometrie und Computergrafik, die Punkte im Raum darstellen. In der dreidimensionalen Modellierung und Grafik sind Vertices die Eckpunkte von Polygonen, üblicherweise Dreiecken oder Vierecken, aus denen die Oberflächen von 3D-Modellen bestehen. Jeder Vertex hat in der Regel mehrere Attribute, die seine Eigenschaften und Rolle innerhalb eines Meshes (ein Netz aus Polygonen) definieren. Der wichtigste Aspekt eines Vertex ist seine Position im Raum, üblicherweise angegeben durch Koordinaten in einem dreidimensionalen Koordinatensystem (x, y, z). Normalen sind Vektoren, die senkrecht auf der Oberfläche eines Polygons stehen und für Beleuchtungsberechnungen wichtig sind, da sie bestimmen, wie Licht von der Oberfläche reflektiert wird. Texturkoordinaten (auch UV-Koordinaten genannt) definieren, wie eine zweidimensionale Textur auf die Oberfläche eines 3D-Modells abgebildet wird. Sie legen fest, welcher Teil der Textur auf einen bestimmten Vertex angewendet wird. Einigen Vertices können auch spezifische Farben zugewiesen werden, die dann zusammen mit Beleuchtungsmodellen und/oder Texturinformationen zur endgültigen Farbe des Pixels beitragen, in dem der Vertex gerendert wird.

In der Computergrafik werden die Vertices eines Modells durch Transformationsmatrizen manipuliert, um Modelle zu skalieren, zu rotieren und zu verschieben. Dies ist ein zentraler Prozess bei der Darstellung von 3D-Modellen auf dem Bildschirm, bei dem die Vertices durch verschiedene Transformationsschritte (Modell-, Ansichts- und Projektionstransformationen) geschickt werden, bevor die endgültige Bildposition eines jeden Vertexes berechnet und das Modell auf dem Bildschirm gerendert wird. Vertices bilden somit die grundlegenden Bausteine für die Darstellung und Manipulation von 3D-Modellen und -Szenen in der Computergrafik.

Es ist zu erwähnen, dass sich die Informationen über Vertices nicht nur auf die Geometrie des mindestens einen Objektes beziehen, sondern auch Informationen über Streueigenschaften des mindestens einen Objektes aufweisen können. Unter dem Begriff "Streuung" wird in dem vorliegenden Zusammenhang jegliche Interaktion des Strahls mit der Oberfläche des mindestens einen Objektes verstanden.

In einem weiteren Aspekt wird vorgeschlagen, dass die Bewegungsinformation des Ego-Fahrzeuges Informationen über eine vorbestimmte Bewegung, insbesondere durch iteratives Angleichen an das generierte Raytracing-Sensorsignal, oder durch einen Fahralgorithmus für eine autonome Fahrfunktion bestimmte Bewegungsinformationen aufweist

Dabei kann eine vorbestimmte Route oder Routenänderung des Ego-Fahrzeuges vorgegeben sein. Auch kann ein Fahrverhalten des Egofahrzeuges in Form eines Fahrtalgorithmus beschrieben sein. Dadurch kann auch ein komplexes Fahrverhalten des Ego-Fahrzeuges abgebildet bzw. beschrieben werden.

In einem weiteren Aspekt wird vorgeschlagen, dass das Verfahren in einem Software-in-a-Loop und/oder einem Hardware-in-a-Loop Testszenario zum Testen des virtuell zu testenden Fahrzeugsensors verwendet wird.

Bei Software-in-the-Loop (SiL) wird die zu testende Software in einer simulierten Umgebung ausgeführt, die in der Regel auf einem Standard-PC oder Server läuft. Es werden keine realen Steuergeräte oder Hardwarekomponenten verwendet; stattdessen werden alle relevanten Systeme und Umgebungen vollständig in Software simuliert. SiL wird verwendet, um das Verhalten der Software unter verschiedenen Betriebsbedingungen zu überprüfen, ohne sich um die Hardwareintegration zu kümmern. Es ermöglicht die frühzeitige Erkennung und Behebung von Softwarefehlern sowie die Überprüfung der Softwarelogik und -funktionalität.

Hardware-in-the-Loop (HiL) Tests integrieren die physische Hardware, z.B. ein Steuergerät, in eine ansonsten simulierte Umgebung. Die Steuergeräte werden mit einer simulierten Umgebung verbunden, die durch spezialisierte HiL-Simulationshardware und -software generiert wird. Sensoren und Aktuatoren werden durch die Simulation ersetzt, während das Steuergerät denkt, es sei in einem realen System verbunden. HiL wird eingesetzt, um die Interaktion zwischen der Hardware und der Software unter realistischen Betriebsbedingungen zu testen, ohne dabei Risiken für Personen oder Material einzugehen. Es ermöglicht das Testen der Reaktion von Steuergeräten auf verschiedenste Eingabesignale und die Überprüfung von Echtzeitfähigkeiten.

In einem weiteren Aspekt wird vorgeschlagen, dass der Fahrzeugsensor einen Lidar-Sensor oder einen Radar-Senor oder einen Ultraschall-Sensor oder einen Infrarot-Sensor aufweist.

Auch weitere Sensorarten sind denkbar, sodass die vorstehende Auflistung nicht einschränkend zu verstehen ist.

In einem weiteren Aspekt ist ein Computerprogramm mit Programmcode beansprucht, um zumindest Teile des vorliegenden Verfahrens in einem seiner Aspekte auszuführen, wenn das Computerprogramm auf einem Computer ausgeführt wird. Mit anderen Worten wird ein Computerprogramm(-produkt), umfassend Befehle, die bei der Ausführung des Programms durch einen Computer diesen veranlassen, das Verfahren/die Schritte des Verfahrens in einem seiner Aspekte auszuführen.

In einem weiteren Aspekt ist ein computerlesbarer Datenträger mit Programmcode eines Computerprogramms vorgeschlagen, um zumindest Teile des vorliegenden Verfahrens in einem seiner Aspekte auszuführen, wenn das Computerprogramm auf einem Computer ausgeführt wird. Mit anderen Worten betrifft die Erfindung ein computerlesbares (Speicher-) Medium, umfassend Befehle, die bei der Ausführung durch einen Computer diesen veranlassen, das Verfahren/die Schritte des Verfahrens in einem seiner Aspekte auszuführen.

Die beschriebenen Ausgestaltungen und Weiterbildungen lassen sich beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: ein schematisches Flussdiagramm eines Ausführungsbeispiels des beanspruchten Verfahrens;
- Fig. 2: eine beispielhafte Veranschaulichung des Verfahrens;
- Fig. 3: eine beispielhafte Veranschaulichung des Verfahrens;
- Fig. 4: eine beispielhafte Veranschaulichung des Verfahrens;
- Fig. 5: eine beispielhafte Veranschaulichung des Verfahrens;
- Fig. 6: eine beispielhafte Veranschaulichung des Verfahrens; und
- Fig. 7: eine schematische Sektionierung eines Raums, in dem mehrere Objekte vorhanden sind.

### Ausführliche Beschreibung der Ausführungsformen

In den Figuren der Zeichnungen bezeichnen gleiche Bezugszeichen gleiche oder funktionsgleiche Elemente, Bauteile oder Komponenten, soweit nichts Gegenteiliges angegeben ist.

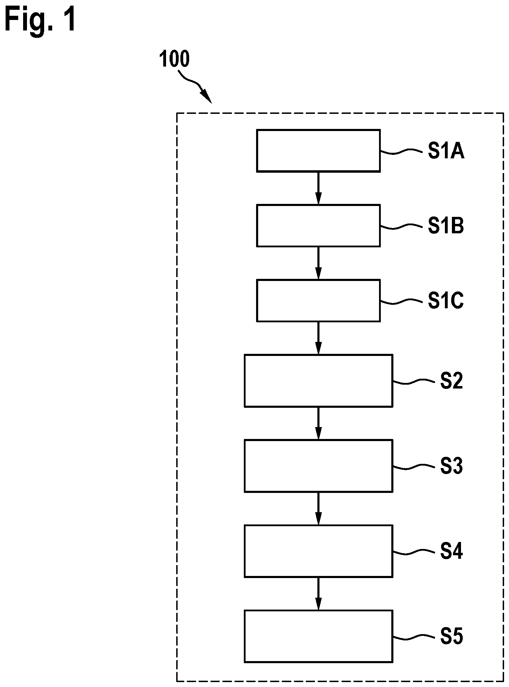

Fig. 1 zeigt ein schematisches Flussdiagramm eines computerimplementierten Verfahrens zum Generieren eines virtuellen Raytracing-Sensorsignals eines virtuell zu testenden Fahrzeugsensors zum Testen einer virtuell simulierten, insbesondere autonomen, Fahrfunktion eines Ego-Fahrzeuges.

Das Verfahren wird vorzugsweise in einem Software-in-a-Loop und/oder einem Hardware-in-a-Loop Testszenario zum Testen des virtuell zu testenden Fahrzeugsensors verwendet.

Das computerimplementierte Verfahren kann in einer beliebigen Ausführungsform zumindest teilweise durch ein System 100 ausgeführt werden, dass hierzu mehrere nicht näher dargestellte Komponenten, beispielsweise eine oder mehrere Bereitstellungseinrichtungen und/oder mindestens eine Auswerte- und Recheneinrichtung umfassen kann. Es versteht sich, dass die Bereitstellungseinrichtung gemeinsam mit der Auswerte- und Recheneinrichtung ausgebildet sein kann, oder von dieser unterschiedlich sein kann. Ferner kann das System 100, das auch ein Teil eines weiteren Systems sein kann, eine Speichereinrichtung und/oder eine Ausgabeeinrichtung und/oder eine Anzeigeeinrichtung und/oder eine Eingabeeinrichtung umfassen.

Das computerimplementierte Verfahren umfasst mindestens die folgenden Schritte:
In einem Schritt S1A erfolgt ein Bereitstellen von Szeneninformationen in einem ersten, insbesondere 64-Bit basierten, Datenformat, wobei die Szeneninformationen Informationen über das Ego-Fahrzeug und mindestens ein Objekt im Raum aufweisen.

In einem Schritt S1B erfolgt ein Bereitstellen der Szeneninformationen in einem zweiten, insbesondere 64-Bit basierten, Datenformat, das auf Basis des ersten Datenformats umgewandelt wird. Bei dem zweiten Datenformat handelt es sich vorzugsweise um ein Unreal 5-Datenformat. Die Szeneninformation weisen beispielsweise eine Bewegungsinformation des Ego-Fahrzeuges und/oder eine Orts- und/oder Bewegungsinformation zu dem mindestens einen Objekt auf.

In einem Schritt S1C erfolgt ein Bereitstellen der Szeneninformationen in einem dritten, insbesondere 32-Bit basierten, Datenformat, das auf Basis des zweiten Datenformats umgewandelt wird, und zum virtuellen Raytracing mindestens eines Objektes im Raum verwendet wird. Bei dem dritten Datenformat handelt es sich vorzugsweise um ein Optix-Datenformat.

In dem dritten Datenformat, in einem Schritt S2 erfolgt ein Unterteilen des Raumes gemäß einem Suchgitter und ein Ermitteln S3, welches des mindestens einen Objektes mit einem approximierten Strahl des virtuell zu testenden Fahrzeugsensors interagiert.

In dem dritten Datenformat, in einem Schritt S4 erfolgt ein virtuelles Raytracing des ermittelten, mindestens einen Objektes.

In einem Schritt S5 erfolgt ein Generieren des virtuellen Raytracing-Sensorsignals auf Basis des getracten, mindestens einen Objektes zum Testen der virtuell simulierten, insbesondere autonomen, Fahrfunktion des Ego-Fahrzeuges. Das virtuelle Raytracing-Sensorsignal weist Informationen über einen Abstand und/oder eine Geschwindigkeit des mindestens einen Objektes relativ zu dem Ego-Fahrzeug auf.

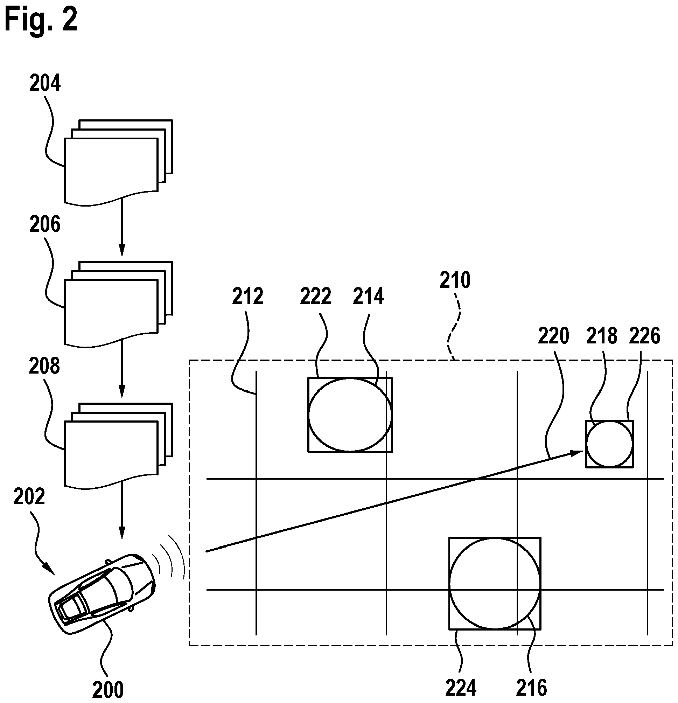

In den Fig. 2 bis 6 sind beispielhafte Veranschaulichungen gezeigt, wie das Verfahren zur Simulation eines Fahrzeugsensors eingesetzt wird. Dabei wird letztlich ein virtuelles Raytracing-Sensorsignal eines virtuell zu testenden Fahrzeugsensors 200 zum Testen einer virtuell simulierten, insbesondere autonomen, Fahrfunktion eines Ego-Fahrzeuges 202 generiert. Zuvor erfolgen allerdings noch einige Datenvorverarbeitungsschritte, um die Simulation genauer zu machen. Der Fahrzeugsensor 200 kann einen Lidar-Sensor oder einen Radar-Senor oder einen Ultraschall-Sensor oder eine Infrarot-Sensor aufweisen.

In Fig. 2 ist eine beispielhafte Szene, die beispielsweise in dem ersten Datenformat (einem Modeldesk-Datenformat) vorliegt, gezeigt. Die Szene wurde, wie zuvor beschrieben, aus einem ersten Datenformat 204 (Modeldesk-Datenformat), in ein zweites Datenformat (Unreal Engine Datenformat) 206, und schließlich in ein drittes Datenformat (Nvidia Optix Datenformat) 208 überführt.

In dem dritten Datenformat, erfolgt dann ein Unterteilen der Szene bzw. eines Raumes 210 gemäß einem Suchgitter 212 und ein Ermitteln, welches des mindestens einen Objektes 214, 216, 218 mit einem approximierten Strahl 220 des virtuell zu testenden Fahrzeugsensors 200 interagiert. Wie aus Fig. 2 zu erkennen ist, interagiert der Strahl 220 nur mit dem Objekt 218 innerhalb des Suchgitters 214. Die Objekte 214 und 216 interagieren hingegen nicht mit dem Strahl 220 und werden somit für die weitere Betrachtung ausgeblendet. Zu jedem der Objekte 214, 216, 218 ist eine Bounding-Box 222, 224, 226 eingezeichnet. Die Bounding-Box-Informationen zu den Objekten 214, 216, 218 werden vorzugsweise in dem zweiten Datenformat 206 bereitgestellt.

Das erste Datenformat 204 weist eine, insbesondere abstrakte, Modellierung des mindestens einen Objekts 214, 216, 218 im Raum 210, einen Verweis und/der Zeiger auf eine detaillierte Beschreibung des mindestens einen Objekts 214, 216, 218 in dem zweiten Datenformat 206 auf. Das erste Datenformat 204 kann ferner Daten und/oder Informationen aus einer Fahrdynamiksimulation des Ego-Fahrzeuges 202 aufweisen.

Das zweite Datenformat 206 kann die detaillierte Beschreibung des mindestens einen Objekts 214, 216, 218 als Informationen über eine Beschaffenheit und/oder eine Oberfläche und/oder eine Oberflächeneigenschaft und/oder eine Objektklasse und/oder einen Objekttyp aufweisen. Das zweite Datenformat 206 kann vorzugsweise ein Unreal Engine Datenformat aufweisen.

Das dritte Datenformat 208 kann Informationen über Vertices, in die eine Oberfläche des mindestens einen Objekt 214, 216, 218 unterteilt ist, aufweisen, wobei die Informationen über die Vertices zum Generieren des virtuellen Raytracing-Sensorsignals in Abhängigkeit des mindestens einen, approximierten Strahl 220 verwendet werden. Das dritte Datenformat 208 kann ein Nvidia Optix-Datenformat aufweisen.

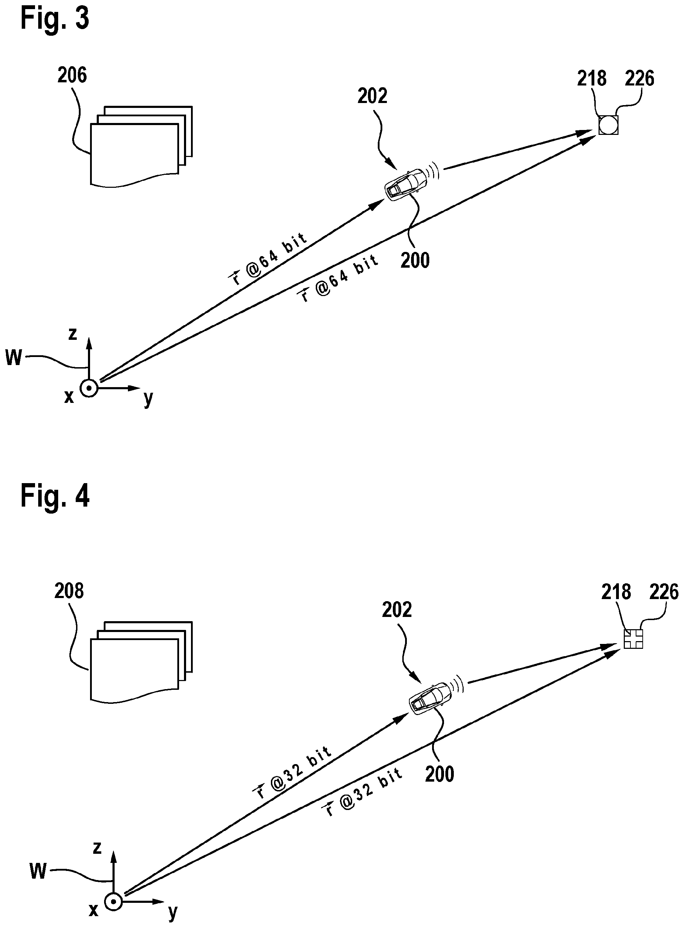

In den Fig. 3 bis 6 ist nur noch das Objekt 218 der sich im Raum 210 befindlichen Objekte 214, 216, 218 dargestellt, da die anderen Objekte 214, 216 durch das Unterteilen des Raumes 210 und das Ermitteln der Interaktion mit dem Strahl 220 für die weitere Auswertung bzw. Analyse vernachlässigt werden. Das Objekt 218 ist mit seiner Bounding-Box 226 dargestellt. Das Objekt 218 ist gemäß Fig. 3 in dem zweiten Datenformat, Unreal Engine 5 dargestellt. Das zweite Datenformat 206 ist ein 64-Bit-Datenformat, sodass die Informationen in einem 64-Bit Format vorliegen.

In Fig. 4 ist das Objekt 218, sowie die Bounding-Box 226 in dem dritten Datenformat 208 dargestellt, welches ein 32-Bit Datenformat ist. Aufgrund der 32-Bit-Darstellung und aufgrund der simulierten Entfernung des Objektes 218 bzw. dem Fahrzeugsensor 200 von einem globalen Koordinaten-Ursprung erscheint die eigentlich runde Oberfläche des Objektes 218 abgestuft, wie dies schematisch aus Fig. 4 hervorgeht. Dies würde nun beim Generieren eines Raytracing-Sensorsignals in der Simulationsumgebung Nvidia Optix zu einer Genauigkeitseinbuße führen, die jedoch durch eine Ausführungsform des vorliegenden Verfahrens umgangen werden kann.

Es kann nämlich vorliegend bevorzugt ein Transformieren von Koordinaten des ermittelten, mindestens einen Objektes 218 aus dem Welt-Koordinatensystem W in ein Koordinatensystem F des virtuell zu testenden Fahrzeugsensors 200 auf Basis von Ortsinformationen, beispielsweise über die Bounding-Box 226, des ermittelten, mindestens einen Objektes 218 und/oder des Fahrzeugsensors 200 erfolgen, die aus dem zweiten Datenformat 206 gewonnen werden.

Alternativ ist es auch denkbar, dass das Transformieren von Koordinaten des Fahrzeugsensors 200 aus dem Welt-Koordinatensystem W in ein Koordinatensystem des ermittelten, mindestens einen Objektes 218 auf Basis von Ortsinformationen des ermittelten, mindestens einen Objektes 218 und/oder des Fahrzeugsensors 200 erfolgt, die aus dem zweiten Datenformat 206 gewonnen werden, und ferner auf Basis von Strahleninformationen des approximierten Strahls.

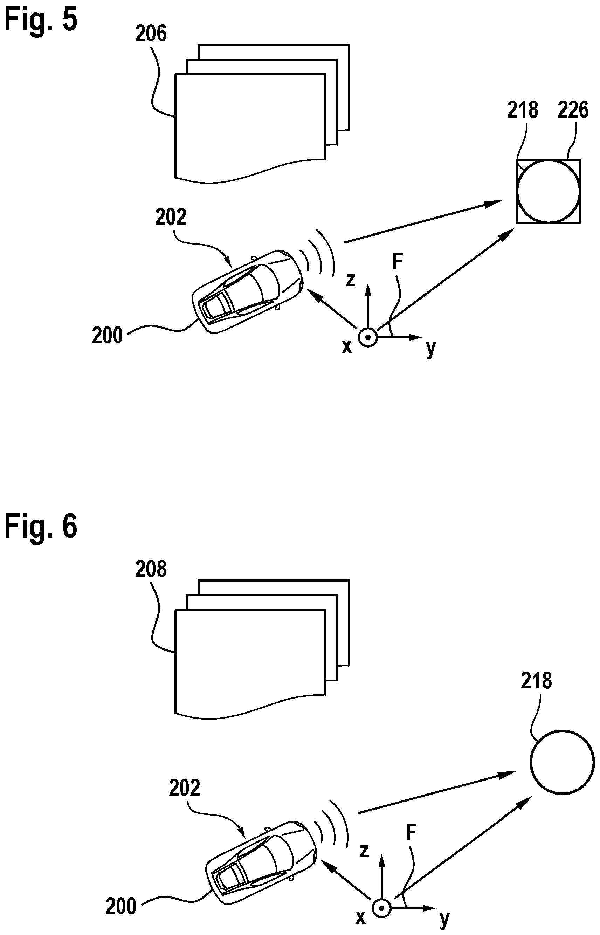

Das Ergebnis der Transformation von dem Koordinatensystem W in das Koordinatensystem F ist in Fig. 5 veranschaulicht. Das Objekt 218 und der Fahrzeugsensor 200 sind nun näher am Koordinatenursprung, sodass die Einträge und die Bezugsinformationen "kleiner" werden. In beiden Fällen wird durch die Koordinatentransformation das (globale) Koordinatensystem W "näher" an den Fahrzeugsensor 200 bzw. das Objekt 218 herangeholt, wie dies auch in Fig. 5 gezeigt ist.

Das Ergebnis der Transformation in gemäß Fig. 5 in dem zweiten Datenformat (Unreal Engine 5) schematisch dargestellt.

Durch die Transformation können nun die Objekteigenschaften der Objektoberfläche des Objektes 218 auch in dem dritten Datenformat 208, das in 32 bit Auflösung vorliegt, als "rund" und nicht mehr als abgestuft dargestellt werden, wie dies aus Fig. 6 hervorgeht. Dadurch kann die Genauigkeit bei der Generierung des virtuellen Raytracing-Sensorsignals erhöht werden.

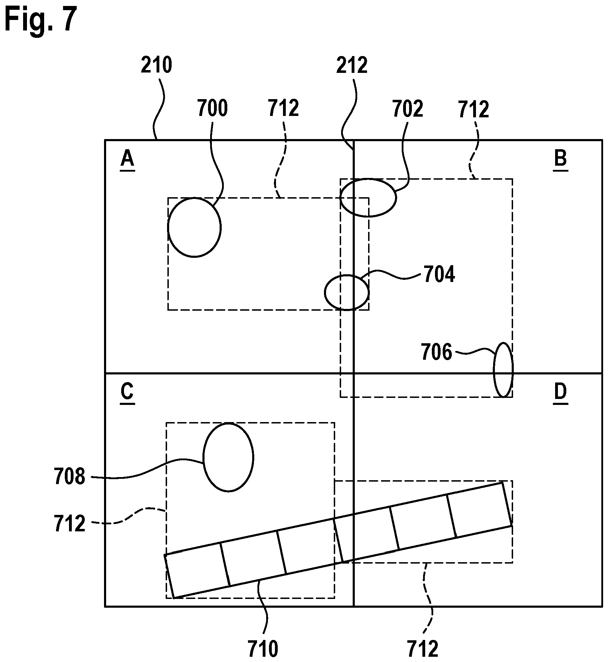

Fig. 7 zeigt eine Aufteilung bzw. Unterteilung des Raumes 210 in vier Sektionen A, B, C, D durch das Suchgitter 212. Dies kann durch einen entsprechenden Algorithmus erfolgen, der die statische Welt bzw. den Raum 210 "sinnvoll" in die Sektionen A, B, C, D aufteilt. Die "optimale" Größe einer Sektion A, B, C, D hängt vorzugsweise mit einer maximalen Sichtweite des Fahrzeugsensors 200 zusammen und kann vorzugsweise entsprechend konfiguriert werden. Die finale Größe einer Sektion A, B, C, D ergibt sich vorzugsweise aus einer jeweils einhüllenden Bounding-Box aller sich im Raum 210 befindlichen Objekte 700, 702, 704, 706, 708, 710, die vorzugsweise ihren jeweiligen Objekt-Mittelpunkt in der jeweiligen Sektion A, B, C, D haben. Eine Sektion A, B, C, D kann dadurch ggf. auch größer werden als ursprünglich definiert. Auch unterschiedliche Größen zwischen Sektionen A, B, C, D sind denkbar. So können rein beispielhaft Sektionen A und B größer oder kleiner als Sektionen C und D sein.

Da im Raum 210, je nach Objektgröße, mehrere Instanzen des gleichen Objekts existieren können, die in dem dritten Datenformat (Optix) insbesondere durch eine einzelne Datenstruktur mit verschiedenen Objekt-zu-Welt Transformationen beschreibbar sind, ist der in Fig. 7 veranschaulichte Ansatz der sektionsübergreifenden Objektzuweisung besser geeignet als die Gitter bzw. Meshes der Objekte 700, 702, 704, 706, 708, 710 an den Sektionsgrenzen zu teilen.

Die Gitter bzw. Meshes größerer Objekte, beispielsweise Objekt 710, die Objekte wie zum Beispiel Straßen oder Gebäude beschreiben können, werden daher vorzugsweise gleichmäßig in kleinere Sub-Sektionen 712 unterteilt, die nur einen Teil der Größe der jeweiligen Sektionen A, B, C, D haben. Dadurch wird erwirkt, dass die einzelnen Sektionen A, B, C, D jeweils höchstens um die Hälfte dieser Unterteilungsgröße mit benachbarten Sektionen überlappen. Durch die sektionsunabhängige Unterteilung können die einzelnen Teil-Meshes so weiterhin Instanziiert werden. Dabei sind die Sektionen A, B, C, D vorzugsweise dreidimensional definiert, sodass z.B. die oberen Teile von Hochhäusern ignoriert werden können, wenn sie nicht im Sichtbereich des Fahrzeugsensors 200 in Bodennähe liegen. Dieses Vorgehen führt zu einer Speicherreduzierung und Performancesteigerung. Um die Zahl der nötigen Checks bei der Generierung des Raytracing-Sensorsignals weiter zu reduzieren, werden die Bounding-Boxen mehrerer benachbarter Sektionen A, B, C, D vorzugsweise auch erneut kombiniert. Es wird dabei vorzugsweise geprüft, ob sich die übergeordnete Bounding-Box in der Reichweite des Fahrzeugsensors 200 befindet. Nur wenn dies der Fall ist, werden die untergeordneten Sub-Sektionen 712 geprüft. Wird diese Sektionierung bzw. Unterteilung des Raums 210 weitergeführt, ergibt sich so vorzugsweise eine Sektions-Baumstruktur. Die Anzahl der für die Generierung des Raytracing-Sensorsignals benötigten Checks pro Sektion und ggf. dieser auch mehrfach untergeordneten (Sub-)Sektion steigt derart lediglich logarithmisch mit der Größe der Szene bzw. des Raums 210 bzw. Anzahl der Sektionen A, B, C, D anstelle von linear an.

Wie anhand des Objekts 710 erkennbar ist, können große Objekte, die in mehreren Sektionen A, B, C, D des Raums 210 vorzufinden sind, in Teilbereiche bzw. Abschnitte (Chunks) des Objekts 710 unterteilt werden. Den jeweiligen Teilbereichen kann dann in der jeweiligen Sektion eine Bounding-Box zugewiesen werden. Die Bounding-Boxen werden kann für die Generierung des Raytracing-Sensorsignals miteinander verbunden. Auch mehrere Objekte innerhalb einer Sektion können mit einer gemeinsamen Bounding-Box zusammengefasst werden, wie dies für die Objekte 700, 704, die Objekte 702, 706, und die Objekte 708, 710 (teilweise) gezeigt ist.

## Patentansprüche

1. Computerimplementiertes Verfahren zum Generieren eines virtuellen Raytracing-Sensorsignals eines virtuell zu testenden Fahrzeugsensors (200) zum Testen einer virtuell simulierten, insbesondere autonomen, Fahrfunktion eines Ego-Fahrzeuges (202), das Verfahren aufweisend die Schritte:
- Bereitstellen (S1A) von Szeneninformationen in einem ersten, insbesondere 64-Bit basierten, Datenformat (204), wobei die Szeneninformationen Informationen über das Ego-Fahrzeug (202) und mindestens ein Objekt (214, 216, 218, 700, 702, 704, 706, 708, 710) im Raum (210) aufweisen;
- Bereitstellen (S1B) der Szeneninformationen in einem zweiten, insbesondere 64-Bit basierten, Datenformat (206), das auf Basis des ersten Datenformats umgewandelt wird;
- Bereitstellen (S1C) der Szeneninformationen in einem dritten, insbesondere 32-Bit basierten, Datenformat (208), das auf Basis des zweiten Datenformats (206) umgewandelt wird, und zum virtuellen Raytracing mindestens eines Objektes (214, 216, 218, 700, 702, 704, 706, 708, 710) im Raum (210) verwendet wird;
- in dem dritten Datenformat (208), Unterteilen (S2) des Raumes (210) gemäß einem Suchgitter (212) und Ermitteln (S3), welches des mindestens einen Objektes (214, 216, 218, 700, 702, 704, 706, 708, 710) mit einem approximierten Strahl (220) des virtuell zu testenden Fahrzeugsensors (200) interagiert;
- in dem dritten Datenformat (208), virtuelles Raytracing (S4) des ermittelten, mindestens einen Objektes (214, 216, 218, 700, 702, 704, 706, 708, 710); und
- Generieren (S5) des virtuellen Raytracing-Sensorsignals auf Basis des getracten, mindestens einen Objektes (214, 216, 218, 700, 702, 704, 706, 708, 710) zum Testen der virtuell simulierten, insbesondere autonomen, Fahrfunktion des Ego-Fahrzeuges (202).

2. Computerimplementiertes Verfahren nach Anspruch 1, ferner aufweisend:
- Transformieren von Koordinaten des ermittelten, mindestens einen Objektes (214, 216, 218, 700, 702, 704, 706, 708, 710) aus dem Welt-Koordinatensystem in ein Koordinatensystem des virtuell zu testenden Fahrzeugsensors (200) auf Basis von Ortsinformationen des ermittelten, mindestens einen Objektes (214, 216, 218, 700, 702, 704, 706, 708, 710) und/oder des Fahrzeugsensors (200), die aus dem zweiten Datenformat (206) gewonnen werden, und auf Basis von Strahleninformationen des approximierten Strahls (220); oder
- Transformieren von Koordinaten des Fahrzeugsensors (200) aus dem Welt-Koordinatensystem in ein Koordinatensystem des ermittelten, mindestens einen Objektes (214, 216, 218, 700, 702, 704, 706, 708, 710) auf Basis von Ortsinformationen des ermittelten, mindestens einen Objektes (214, 216, 218, 700, 702, 704, 706, 708, 710) und/oder des Fahrzeugsensors (200), die aus dem zweiten Datenformat (206) gewonnen werden, und auf Basis von Strahleninformationen des approximierten Strahls (220).

3. Computerimplementiertes Verfahren nach Anspruch 2, wobei die Ortsinformationen des ermittelten, mindestens einen Objektes (214, 216, 218, 700, 702, 704, 706, 708, 710) und/oder des Fahrzeugsensors (200), die aus dem zweiten (206) Datenformat gewonnen werden, Informationen über Koeffizienten einer Transformationsmatrix aufweisen.

4. Computerimplementiertes Verfahren nach einem der vorstehenden Ansprüche, wobei die Szeneninformation ferner eine Bewegungsinformation des Ego-Fahrzeuges (202) und/oder eine Orts- und/oder Bewegungsinformation zu dem mindestens einen Objekt (214, 216, 218, 700, 702, 704, 706, 708, 710) aufweist.

5. Computerimplementiertes Verfahren nach einem der vorstehenden Ansprüche, wobei das virtuelle Raytracing-Sensorsignal Informationen über einen Abstand und/oder eine Geschwindigkeit des mindestens einen Objektes (214, 216, 218, 700, 702, 704, 706, 708, 710) relativ zu dem Ego-Fahrzeug (202) aufweist.

6. Computerimplementiertes Verfahren nach einem der vorstehenden Ansprüche, wobei das erste Datenformat (204) eine, insbesondere abstrakte, Modellierung des mindestens einen Objekts (214, 216, 218, 700, 702, 704, 706, 708, 710) im Raum (210), einen Verweis und/der Zeiger auf eine detaillierte Beschreibung des mindestens einen Objekts (214, 216, 218, 700, 702, 704, 706, 708, 710) in dem zweiten Datenformat (206) aufweist, und wobei das erste Datenformat (204) vorzugsweise ein Modeldesk-Datenformat aufweist.

7. Computerimplementiertes Verfahren nach Anspruch 6, wobei das erste Datenformat (204) ferner Daten und/oder Informationen aus einer Fahrdynamiksimulation des Ego-Fahrzeuges (202) aufweist.

8. Computerimplementiertes Verfahren nach Anspruch 6 oder 7, wobei das zweite Datenformat (206) die detaillierte Beschreibung des mindestens einen Objekts (214, 216, 218, 700, 702, 704, 706, 708, 710) als Informationen über eine Beschaffenheit und/oder eine Oberfläche und/oder eine Oberflächeneigenschaft und/oder eine Objektklasse und/oder einen Objekttyp aufweist, und wobei das zweite Datenformat (206) vorzugsweise ein Unreal Engine Datenformat aufweist.

9. Computerimplementiertes Verfahren nach einem der vorstehenden Ansprüche, wobei das dritte Datenformat (208) Informationen über Vertices, in die eine Oberfläche des mindestens einen Objekt (214, 216, 218, 700, 702, 704, 706, 708, 710) unterteilt ist, aufweist, wobei die Informationen über die Vertices zum Generieren (S5) des virtuellen Raytracing-Sensorsignals in Abhängigkeit des mindestens einen, approximierten Strahl (220) verwendet werden, wobei das dritte Datenformat (208) ein Nvidia Optix-Datenformat aufweist.

10. Computerimplementiertes Verfahren nach Anspruch 4, wobei die Bewegungsinformation des Ego-Fahrzeuges (202) Informationen über eine vorbestimmte Bewegung, insbesondere durch iteratives Angleichen an das generierte Raytracing-Sensorsignal, oder durch einen Fahralgorithmus für eine autonome Fahrfunktion bestimmte Bewegungsinformationen aufweist.

11. Computerimplementiertes Verfahren nach einem der vorstehenden Ansprüche, wobei das Verfahren in einem Software-in-a-Loop und/oder einem Hardware-in-a-Loop Testszenario zum Testen des virtuell zu testenden Fahrzeugsensors (200) verwendet wird.

12. Computerimplementiertes Verfahren nach einem der vorstehenden Ansprüche, wobei der Fahrzeugsensor (200) einen Lidar-Sensor oder einen Radar-Senor oder einen Ultraschall-Sensor oder eine Infrarot-Sensor aufweist.

13. System (100) zum Generieren eines virtuellen Raytracing-Sensorsignals eines virtuell zu testenden Fahrzeugsensors (200) zum Testen einer virtuell simulierten, insbesondere autonomen, Fahrfunktion eines Ego-Fahrzeuges (202), das System (100) aufweisend eine Auswerte- und Recheneinrichtung, die dazu ausgebildet ist, die folgenden Schritte auszuführen:
- Bereitstellen (S1A) von Szeneninformationen in einem ersten, insbesondere 64-Bit basierten, Datenformat (204), wobei die Szeneninformationen Informationen über das Ego-Fahrzeug (202) und mindestens ein Objekt (214, 216, 218, 700, 702, 704, 706, 708, 710) im Raum (210) aufweisen;
- Bereitstellen (S1B) der Szeneninformationen in einem zweiten, insbesondere 64-Bit basierten, Datenformat (206), das auf Basis des ersten Datenformats umgewandelt wird;
- Bereitstellen (S1C) der Szeneninformationen in einem dritten, insbesondere 32-Bit basierten, Datenformat (208), das auf Basis des zweiten Datenformats umgewandelt wird, und zum virtuellen Raytracing mindestens eines Objektes (214, 216, 218, 700, 702, 704, 706, 708, 710) im Raum (210) verwendet wird;
- in dem dritten Datenformat (208), Unterteilen (S2) des Raumes gemäß einem Suchgitter (212) und Ermitteln (S3), welches des mindestens einen Objektes (214, 216, 218, 700, 702, 704, 706, 708, 710) mit einem approximierten Strahl (220) des virtuell zu testenden Fahrzeugsensors (200) interagiert;
- in dem dritten Datenformat (208), virtuelles Raytracing (S5) des ermittelten, mindestens einen Objektes (214, 216, 218, 700, 702, 704, 706, 708, 710); und
- Generieren (S6) des virtuellen Raytracing-Sensorsignals auf Basis des getracten, mindestens einen Objektes (214, 216, 218, 700, 702, 704, 706, 708, 710) zum Testen der virtuell simulierten, insbesondere autonomen, Fahrfunktion des Ego-Fahrzeuges (202).

14. Computerprogrammprodukt mit einem Computerprogramm, das Softwaremittel zur Durchführung des Verfahrens nach einem der Ansprüche 1 bis 12 umfasst, wobei das Computerprogramm auf einem Computer ausgeführt wird.

15. Computerlesbarer Datenträger mit Programmcode eines Computerprogramms, um zumindest Teile eines Verfahrens nach einem der Ansprüche 1 bis 12 auszuführen, wenn das Computerprogramm auf einem Computer ausgeführt wird.

16. Computerimplementiertes Verfahren zum Generieren eines virtuellen Raytracing-Sensorsignals eines virtuell zu testenden Fahrzeugsensors (200) zum Testen einer virtuell simulierten, insbesondere autonomen, Fahrfunktion eines Ego-Fahrzeuges (202), das Verfahren aufweisend die Schritte:
- Bereitstellen (S1A) von Szeneninformationen in einem ersten, insbesondere 64-Bit basierten, Datenformat (204), wobei die Szeneninformationen Informationen über das Ego-Fahrzeug (202) und mindestens ein Objekt (214, 216, 218, 700, 702, 704, 706, 708, 710) im Raum (210) aufweisen;
- Bereitstellen (S1C) der Szeneninformationen in einem dritten, insbesondere 32-Bit basierten, Datenformat (208), das auf Basis des ersten Datenformats (206) umgewandelt wird, und zum virtuellen Raytracing mindestens eines Objektes (214, 216, 218, 700, 702, 704, 706, 708, 710) im Raum (210) verwendet wird;
- in dem dritten Datenformat (208), Unterteilen (S2) des Raumes (210) gemäß einem Suchgitter (212) und Ermitteln (S3), welches des mindestens einen Objektes (214, 216, 218, 700, 702, 704, 706, 708, 710) mit einem approximierten Strahl (220) des virtuell zu testenden Fahrzeugsensors (200) interagiert;
- in dem dritten Datenformat (208), virtuelles Raytracing (S4) des ermittelten, mindestens einen Objektes (214, 216, 218, 700, 702, 704, 706, 708, 710); und
- Generieren (S5) des virtuellen Raytracing-Sensorsignals auf Basis des getracten, mindestens einen Objektes (214, 216, 218, 700, 702, 704, 706, 708, 710) zum Testen der virtuell simulierten, insbesondere autonomen, Fahrfunktion des Ego-Fahrzeuges (202).
